# EUROPEAN PATENT SPECIFICATION

(11) **EP 3 783 705 B1**
(45) Date of publication and mention of the grant of the patent: **11.06.2025**
(21) Application number: 19914181.3
(22) Date of filing: 06.12.2019
(51) Int. Cl.: H01M 4/36, H01M 4/131, H01M 4/62, H01M 10/0562, H01M 10/0525, H01M 4/1391, H01M 4/525, H01M 4/02

(54) **POSITIVE ELECTRODE ACTIVE MATERIAL FOR ALL-SOLID-STATE LITHIUM ION BATTERIES, POSITIVE ELECTRODE FOR ALL-SOLID-STATE LITHIUM ION BATTERIES, ALL-SOLID-STATE LITHIUM ION BATTERY, AND METHOD FOR PRODUCING POSITIVE ELECTRODE ACTIVE MATERIAL FOR ALL-SOLID-STATE LITHIUM ION BATTERIES**
POSITIVELEKTRODEN-AKTIVMATERIAL FÜR FESTKÖRPER-LITHIUM-IONEN-BATTERIEN, POSITIVE ELEKTRODE FÜR FESTKÖRPER-LITHIUM-IONEN-BATTERIEN, FESTKÖRPER-LITHIUM-IONENBATTERIE UND VERFAHREN ZUR HERSTELLUNG VON POSITIVELEKTRODEN-AKTIVMATERIAL FÜR FESTKÖRPER-LITHIUM-IONEN-BATTERIEN
MATÉRIAU ACTIF D'ÉLECTRODE POSITIVE POUR BATTERIES À L'ION LITHIUM À L'ÉTAT TOUT SOLIDE, ÉLECTRODE POSITIVE POUR BATTERIES À L'ION LITHIUM À L'ÉTAT TOUT SOLIDE, BATTERIE À L'ION LITHIUM À L'ÉTAT TOUT SOLIDE ET PROCÉDÉ DE PRODUCTION D'UN MATÉRIAU ACTIF D'ÉLECTRODE POSITIVE POUR DES BATTERIES À L'ION LITHIUM À L'ÉTAT TOUT SOLIDE

(30) Priority: 24.06.2019 JP 2019116758
(43) Date of publication of application: 24.02.2021
(73) Proprietor: JX Advanced Metals Corporation, Tokyo 105-8417 (JP)
(72) Inventor: KASHIMURA, Toshihide, Kitaibaraki-shi Ibaraki 3191535 (JP)
(74) Representative: Yeadon IP Limited
(86) International application number: PCT/JP2019/047955
(87) International publication number: WO 2020/261600

(56) References cited:
- WO-A1-2012/157046
- CN-A- 106 935 832
- JP-A- 2004 250 771
- JP-A- 2012 256 550
- JP-A- 2016 009 614
- JP-A- 2016 072 177
- JP-A- 2016 103 411
- JP-A- 2017 098 196
- JP-A- 2018 116 784
- JP-A- 2019 091 686
- US-A1- 2018 212 233

## Description

### FIELD OF THE INVENTION

The present invention relates to a positive electrode active material for all-solid lithium ion batteries, a positive electrode for all-solid lithium ion batteries, an all-solid lithium ion battery, and a method for producing a positive-electrode active material for all-solid lithium ion batteries.

### BACKGROUND OF THE INVENTION

Currently, lithium ion batteries use a layered compound LiMeO₂ in which Me is a cation selected to have a +III valency on average and necessarily contains a redox cation; a spinel compound LiMeQO₄ in which Q is a cation selected to have a +IV valency on average); an olivine compound LiX¹X²O₄ in which X¹ is a cation selected to have a +II valency and necessarily contains a redox cation, and X² is a cation selected to have a +V valency); or a fluorite compound Li₅MeO₄, as a positive electrode active material. On the other hand, electrolytic solutions or other constituent requirements have been improved year by year in order to utilize its characteristics.

However, for the lithium ion batteries, most of the electrolytes are organic compounds, and even if a flame-retardant compound is used, any risk of causing a fire could not be completely eliminated. As an alternative candidate for such liquid-type lithium ion batteries, all-solid lithium ion batteries having a solid electrolyte have been attracting attention in recent years. Among others, an all-solid lithium ion battery containing a sulfide such as Li₂S-P₂S₅ or the sulfide to which a lithium halide is added, as a solid electrolyte, is becoming mainstream.

In the all-solid lithium ion batteries, it is common to cover a surface of a positive electrode active material in order to prevent a high-resistivity layer from being produced at an interface between the positive electrode active material and the sulfide-based solid electrolyte.

For example, Patent Literature 1 discloses that a positive electrode active material is covered with a reaction-inhibiting layer of Li₃BO₃-Li₄SiO₄ containing carbon.

### CITATION LIST

### Patent Literature

[Patent Literature 1] Japanese Patent Application Publication No. 2012-243443 A

### In other prior art:

US 2018/212233 A1 discloses a composite cathode active material for a solid state secondary battery, including a core particle, a first coating layer and a second coating layer, wherein the core particle includes a cathode active material, the first and second coating layers cover a surface of the core particle, the first coating layer includes a first lithium-containing compound which includes Zr, Nb, Ti, Al or a combination thereof, the second coating layer includes a second lithium-containing compound which includes Ge, Ni, Ga, or a combination thereof, and the first lithium-containing compound is different from the second lithium-containing compound.

JP 2017/098196 A discloses a positive electrode active material for a nonaqueous electrolyte secondary battery, comprising lithium nickel composite oxide particles, each having a lithium compound layer on at least part of its surface and a composition given by the formula Liₜ₁Ni_{1-x-y}CoₓM1_{y}M2_{z}O₂ (where M1 and M2 represent at least one element selected from a group consisting of Mg, Al, Ca, Ti, V, Cr, Mn, Zr, Nb, Mo and W, 0.97 < t1 ≤ 1.10, 0 ≤ x ≤ 0.22, 0 ≤ y ≤ 0.15, 0 < z ≤ 0.05. The lithium compound layer comprises a lithium compound including Li and M2, has a thickness of 5-500 nm and a concentration gradient such that the concentration of M2 lowers in a direction from the outermost surface of the composite oxide particle toward the centre thereof.

CN 106 935 832 A discloses a manganese-lithium phosphate composite material for a cathode of a lithium ion battery, comprising a LiMnPO₄ core, a LiNbO₃ first coating layer and a C second coating layer, wherein the LiNbO₃ layer coats the surface of the LiMnPO₄ core, and the C layer coats the surface of the LiNbO₃ layer.

### SUMMARY OF THE INVENTION

### Technical Problem

However, the carbon in the coated layer contains not only a simple substance but also oxides, hydroxides, or the like, so that the resistance is higher and sufficient output characteristics cannot be obtained. Further, the effect of suppressing the reaction with the sulfide-based solid electrolyte is reduced due to the carbon in the coated layer, resulting in insufficient suppression of generation of the high resistivity layer.

An object of the present invention is to provide a positive electrode active material for all-solid lithium ion batteries, which suppresses generation of ahigh-resistivity layer at an interface with a sulfide-based solid electrolyte, has improved electron conductivity, and exhibits good output characteristics when applied to all-solid lithium ion batteries; a positive electrode for all-solid lithium ion batteries using the same; an all-solid lithium ion battery; and a method for producing a positive electrode active material for all-solid lithium ion batteries.

As a result of various studies, the present inventors have found that the above problems can be solved by a positive electrode active material for all-solid lithium ion batteries including a core positive electrode active material having a predetermined composition and a coated portion formed on a surface of the core positive electrode active material, in which the coated portion is formed of lithium niobate and carbon.

In one aspect, the present invention completed on the basis of the above findings relates to a positive electrode active material for all-solid lithium ion batteries, the positive electrode active material comprising: a core positive electrode active material having a composition represented by the following formula: LiₐNi_{b}Co_{c}M_{d}O₂ in which M is at least one element selected from Mn, V, Mg, Ti and Al, 1.00 ≤ a ≤ 1.02, 0.8 ≤ b ≤ 0.9, and b + c + d = 1; and a coated portion formed on a surface of the core positive electrode active material, wherein the coated portion comprises a layer of lithium niobate and a carbon layer in this order, from the surface of the core positive electrode active material, and wherein a ratio of a content of Nb in the coated portion is from 0.5 to 1.5 mol% relative to the total content of Ni, Co and M in the core positive electrode active material, and a ratio of a content of carbon in the coated portion is from 10 to 50 mol% relative to the content of Nb in the coated portion.

In an embodiment of the positive electrode active material for all-solid lithium ion batteries according to the present invention, the carbon of the coated portion is elemental carbon.

In another aspect, the present invention relates to a positive electrode for all-solid lithium ion batteries, comprising the positive-electrode active material for all-solid lithium ion batteries according to the first aspect of the present invention.

In yet another aspect, the present invention provides an all-solid lithium ion battery, comprising: the positive electrode for all-solid lithium ion batteries according to the preceding aspect of the present invention; a negative electrode; and a solid electrolyte.

In still another aspect of the present invention, there is provided a method for producing the positive electrode active material for all-solid lithium ion batteries according to the first aspect of the present invention, the method comprising: coating the entire surface of the core positive electrode active material with lithium niobate; and after coating the entire surface with the lithium niobate, further coating it with carbon using a carbon target material by means of barrel sputtering.

According to the present invention, it is possible to provide a positive electrode active material for all-solid lithium ion batteries, which suppresses generation of a high-resistivity layer at an interface with a sulfide-based solid electrolyte, has improved electron conductivity, and exhibits good output characteristics when applied to all-solid lithium ion batteries; a positive electrode for all-solid lithium ion batteries using the same; an all-solid lithium ion battery; and a method for producing a positive-electrode active material for all-solid lithium ion batteries.

### DETAILED DESCRIPTION OF THE INVENTION

### (Positive Electrode Active Material for All-Solid-State Lithium Ion Batteries)

A positive electrode active material for all-solid lithium ion batteries according to the present invention includes: a core positive electrode active material having a composition represented by the following formula:

LiₐNi_{b}Co_{c}M_{d}O₂

in which M is at least one element selected from Mn, V, Mg, Ti and Al, 1.00 ≤ a ≤ 1.02, 0.8 ≤ b ≤ 0.9, and b + c + d = 1; and a coated portion formed on a surface of the core positive electrode active material, wherein the coated portion comprises a layer of lithium niobate and a carbon layer in this order, from the surface of the core positive electrode active material, wherein a ratio of a content of Nb in the coated portion is from 0.5 to 1.5 mol% relative to the total content of Ni, Co and M in the core positive electrode active material, and wherein a ratio of a content of carbon in the coated portion is from 10 to 50 mol % relative to the content of Nb in the coated portion.

In the all-solid lithium ion batteries, it is conventionally said that the coating of LiNbO₃ on surfaces of positive electrode active material particles improves battery characteristics as compared with a case of no coating. This is because although an energy gap at a positive electrode-electrolyte interface tends to increase when a general oxide positive electrode active material or a sulfide-based solid electrolyte is used as an electrolyte, the total energy gap at the positive electrode-electrolyte interface is decreased by placing LiNbO₃ having a crystal lattice relaxation effect therebetween. However, there are problems that although the LiNbO₃ coating suppresses the reaction between the sulfide-based electrolyte and the positive electrode material and formation of the high-resistivity layer can be suppressed, the resistance of the entire active material including the coated layer is higher and sufficient output characteristics and cycle characteristics cannot be obtained.

Further, conventionally, there is a technique of coating a positive electrode active material with a reaction-inhibiting layer of carbon-containing Li₃BO₃-Li₄SiO₄ to provide a positive electrode having improved electron conductivity. However, since the carbon in the coated layer includes not only a single substance but also oxides and hydroxides, the resistance is higher so that sufficient output characteristics cannot be obtained. Further, the effect of suppressing the reaction with the sulfide-based solid electrolyte is reduced due to the carbon of the coated layer, resulting in insufficient suppression of generation of the high-resistivity layer.

On the other hand, the coated portion of the positive electrode active material for all solid-state lithium ion batteries according to the present invention has a layer of lithium niobate and a layer of carbon in this order from the surface of the core positive electrode active material. In other words, the positive electrode active material for all-solid lithium ion batteries according to the present invention has a structure in which the surface of the core positive electrode active material is covered with lithium niobate as a reaction-inhibiting layer and the surface of the lithium niobate is covered with carbon. According to this structure, the core positive electrode active material is coated with carbon-free lithium niobate, which forms an inner layer of the coated portion, so that the formation of the high-resistivity layer is suppressed. Furthermore, electronic conductivity can be improved by coating an outer layer of the coated portion with carbon which forms an outer layer of the coated portion. Then, the ionic and electronic conductivity at the interface between the positive electrode active material and the solid electrolyte is improved, whereby an all-solid battery having improved output and cycling characteristics can be obtained.

For the positive electrode active material for all solid-state lithium ion batteries according to the invention, a ratio of a content of Nb in the coated portion is preferably from 0.5 to 1.5 mol% relative to the total content of Ni, Co and M in the core positive electrode active material. According to this configuration, when used in an all-solid lithium ion battery, the positive electrode active material can lead to decreased capacity degradation of that battery, resulting in improved output and cycling characteristics. The ratio of the content of Nb in the coated portion may be 0.6 mol% or more, 0.8 mol % or more, or 1.0 mol % or more, and 1.4 mol % or less, 1.2 mol % or less, or 1.0 mol % or less, relative to the total content of Ni, Co and M in the core positive electrode active material.

For the positive electrode active material for all solid-state lithium ion batteries according to the invention, a ratio of a content of carbon in the coated portion is preferably from 10 to 50 mol% relative to the content of Nb in the coated portion. The ratio of the content of carbon in the coated portion of 10 mol% or more relative to the content of Nb in the coated portion can provide further improvement of electronic conductivity at the interface between the positive electrode active material and the solid electrolyte. Further, the ratio of the content of carbon in the coated portion of 50 mol% or less relative to the content of Nb in the coated portion can provide further improvement of ionic conductivity at the interface between the positive electrode active material and the solid electrolyte. The ratio of the content of carbon in the coated portion may be 20 mol% or more, or 30 mol% or more, and 40 mol% or less, or 30 mol% or less, relative to the content of Nb in the coated portion.

If the coated portion also contain oxides, hydroxides or the like, the resistance will be increased, so that sufficient output characteristics may not be obtained. Therefore, for the positive electrode active material for all solid-state lithium-ion batteries according to an embodiment of the present invention, the carbon of the coated portion is preferably elemental carbon.

For the positive electrode active material for all-solid lithium ion batteries according to the present invention, the coated portion has a layer of lithium niobate and a layer of carbon in this order from the surface of the core positive electrode active material. According to the structure, the carbon in the upper layer of the coated portion can further improve electronic conductivity, thereby further reducing the resistance of the positive electrode active material. Further, since the core positive electrode active material is coated with lithium niobate in the lower layer of the coated portion, the formation of the high-resistivity layer by the reaction with the sulfide-based solid electrolyte is more satisfactorily suppressed. As a result, the ionic and electronic conductivity at the interface between the positive electrode active materials and at the interface between the positive electrode and solid electrolyte can be further improved, thereby providing an all-solid battery having improved output characteristics.

### (Lithium Ion Battery)

A positive electrode for all-solid lithium ion batteries positive electrode can be produced using the positive electrode active material for all-solid lithium ion batteries according to the present invention, and an all-solid lithium ion battery can be further produced using the positive electrode for all-solid lithium ion batteries, a negative electrode, and a solid electrolyte.

### (Method for Producing Positive Electrode Active Material for All-Solid-State Lithium Ion Batteries)

Next, a method for producing the positive electrode active material for all-solid lithium ion batteries according to an embodiment of the method aspect of the present invention will be described in detail.

### (1) Production Step of Core Positive Electrode Active Material

The method for producing the core positive electrode active material according to the embodiment of the present invention starts from preparation of a Ni/Co/M composite hydroxide having a Ni composition of 0.8 or more in molar ratio, or a precursor of the Ni/Co/M composite hydroxide. Herein, M is at least one element selected from Mn, V, Mg, Ti and Al. Subsequently, a Li source (Li carbonate, Li hydroxide, etc.) is mixed with the composite hydroxide by dry mixing with a Henschel mixer or the like in an adjusted mixing ratio of the respective raw materials, and then fired at a temperature of 700 to 800 °C for 12 to 24 hours to obtain a fired body. If necessary, the fired body is then pulverized using, for example, a pulverizer, to obtain powder of the core positive electrode active material.

### (2) Coating Step of Core Positive Electrode Active Material

In a coating method according to an embodiment of the present invention, the powder of the above core positive electrode active material is fully coated with lithium niobate. The coating method is not particularly limited, but, for example, lithium niobate can be coated on the surface of the core positive electrode active material using a solution containing LiOC₂H₅ and Nb(OC₂H₅)₅ by means of a certain coating device.

Sputtering is then carried out using a carbon target material by means of barrel sputtering apparatus, thereby further coating with carbon the core positive electrode active material which has been fully coated with lithium niobate. The positive electrode active material for all-solid lithium ion batteries according to the embodiment of the present invention can be thus produced.

### EXAMPLES

While Examples are provided below for better understanding of the invention and its advantages, the present invention is not limited to these Examples.

### [Example 1]

### (1) Production Step of Core Positive Electrode Active Material

Commercially available nickel sulfate, cobalt sulfate, and manganese sulfate were mixed as an aqueous solution such that a molar ratio of Ni, Co, and M would reach a predetermined value, and co-precipitated with an alkaline (sodium hydroxide) solution with sufficiently stirring, and then filtred and washed. The reaction method was carried out according to the standard method. Subsequently, the above coprecipitate was mixed with lithium hydroxide monohydrate such that a molar ratio of Li to the total of Ni, Co and M (Li / (Ni + Co + M)) would reach a predetermined value, and fired in a roller hearth kiln (at a calcination temperature of 720°C for a calcination time of 24 hours), and then pulverized using a roll mill and pulverizer to obtain a core positive electrode active material having a particle diameter (D50) of 4.5 µm.

### (2) Coating Step of Core Positive Electrode Active Material

The surface of the core positive electrode active material Li_{1.02}Ni_{0.82}CO_{0.15}Mn_{0.03}O₂ was coated with 1.0 mol% of LiNbO₃ using a solution containing LiOC₂H₅ and Nb(OCC₂H₅)₅ by means of a rolling fluidized bed coating apparatus. The powder coated with LiNbO₃ was then placed in the barrel sputtering apparatus, and barrel sputtering was carried out using a carbon (C) target material under a condition of an output of 300 to 700W to coat elemental carbon so as to have 30mol% relative to Nb. A heat treatment was carried out at 400°C for one hour to obtain a positive electrode active material in which the core positive electrode active material was coated with lithium niobate and elemental carbon.

### [Example 2]

A positive electrode active material in which lithium niobate and elemental carbon were coated on the core positive electrode active material was obtained in the same method as that of Example 1, with the exception that elemental carbon was coated so as to have 10 mol% relative to Nb.

### [Example 3]

A positive electrode active material in which lithium niobate and elemental carbon were coated on the core positive electrode active material was obtained in the same method as that of Example 1, with the exception that elemental carbon was coated so as to have 50 mol% relative to Nb.

### [Example 4]

A positive electrode active material in which lithium niobate and elemental carbon were coated on the core positive electrode active material was obtained in the same method as that of Example 1, with the exception that 0.5 mol% of LiNbO₃ was coated.

### [Example 5]

A positive electrode active material in which lithium niobate and elemental carbon were coated on the core positive electrode active material was obtained in the same method as that of Example 1, with the exception that 1.5 mol% of LiNbO₃ was coated.

### [Example 6]

A positive electrode active material in which lithium niobate and elemental carbon were coated on the core positive electrode active material was obtained in the same method as that of Example 1, with the exception that the composition of the core positive electrode active material was Li_{1.00}Ni_{0.82}Co_{0.15}Mn_{0.03}O₂.

### [Example 7]

A positive electrode active material in which lithium niobate and elemental carbon were coated on the core positive electrode active material was obtained in the same method as that of Example 1, with the exception that the composition of the core positive electrode active material was Li_{1.02}Ni_{0.90}Co_{0.07}Mn_{0.03}O₂.

### [Example 8]

A positive electrode active material in which lithium niobate and elemental carbon were coated on the core positive electrode active material was obtained in the same method as that of Example 1, with the exception that the composition of the core positive electrode active material was Li_{1.02}Ni_{0.82}Co_{0.15}V_{0.03}O₂.

### [Example 9]

A positive electrode active material in which lithium niobate and elemental carbon were coated on the core positive electrode active material was obtained in the same method as that of Example 1, with the exception that the composition of the core positive electrode active material was Li_{1.02}Ni_{0.82}CO_{0.15}Mg_{0.03}O₂.

### [Example 10]

A positive electrode active material in which lithium niobate and elemental carbon were coated on the core positive electrode active material was obtained in the same method as that of Example 1, with the exception that the composition of the core positive electrode active material was Li_{1.02}Ni_{0.82}Co_{0.15}Ti_{0.03}O₂.

### [Example 11]

A positive electrode active material in which lithium niobate and elemental carbon were coated on the core positive electrode active material was obtained in the same method as that of Example 1, with the exception that the composition of the core positive electrode active material was Li_{1.02}Ni_{0.82}Co_{0.15}Al_{0.03}O₂.

### [Comparative Example 1]

A core positive electrode active material Li_{1.02}Ni_{0.82}Co_{0.15}Mn_{0.03}O₂ was prepared in the same method as that of Example 1, and a surface of the core positive electrode active material was coated with 1.0 mol% of LiNbO₃ using a solution containing LiOC₂H₅ and Nb(OC₂H₅)₅ by means of a rolling fluidized bed coating apparatus. A heat treatment was then carried out at 400 °C for one hour to obtain a positive electrode active material in which lithium niobate and elemental carbon were coated on the core positive electrode active material.

### (Evaluation)

Each Evaluation was carried out under the following conditions using samples of the respective Examples and Comparative Examples thus produced.

### - Evaluation of Composition of Core Positive Electrode Active Material And Coated Portion -

The compositions of the core positive electrode active material and a coated layer 1 (a layer of lithium niobate) of the coated portion were evaluated using an inductively coupled plasma (ICP) emission spectroscopy analyzer. A coated layer 2 (a layer of elemental carbon) of the coated portion was evaluated by a non-dispersive infrared analysis method using a CHN analyzer.

### - Evaluation of Battery Characteristics (All-Solid Lithium Ion Battery) -

Each of the positive electrode active materials of Examples and Comparative Examples and LPS (0.75Li₂S-0.25P₂S₅) were weighed in a ratio of 7:3 and mixed to obtain a positive electrode mixture. A mold having an inner diameter of 10 mm was filled with a Li-In alloy, LPS (0.75Li₂S-0.25P₂S₅), the positive electrode mixture, and an Al foil in this order, and pressed at 500 MPa. The resulting pressed body was restrained at 100 MPa using a metallic jig to produce an all-solid lithium ion battery. For the battery, an initial capacity (at 25 °C, a charge upper limit voltage of 3.7 V, a discharge lower limit voltage of 2.5 V) obtained at a charge/discharge rate of 0.05 C was measured, which was defined as a discharge capacity 1. The charging/discharging was then repeated ten times at a charge/discharge rate of 1 C (at 25 °C, a charge upper limit voltage of 3.7 V, a discharge lower limit voltage of 2.5 V). The capacity obtained by the first discharge at the charge/discharge rate of 1 C was defined as a discharge capacity 2, and a ratio of (discharge capacity 2) / (discharge capacity 1) was determined to be an output characteristic (%) in percentage.

Table 1 shows the evaluation conditions and results.

**Table 1**

| | Composition of Core Positive Electrode Active Material: LiₐNi_{b}Co_{c}M_{d}O₂ | | | | | Coated Layer 1 | Coated Layer 2 | Discharge Capacity 1 | Discharge Capacity 2 | Output Characteristic |
|---|---|---|---|---|---|---|---|---|---|---|
| | | | | | | LiNbO₃ | C | | | |
| | Li | Ni/ (Ni+Co+M) | Co/ (Ni+Co+M) | M/ (Ni+Co+M) | M | Nb/ (Ni+Co+M) | C/Nb | 0.05C Load | 1C Load | Maintenance Rate |
| | (a) | (b) | (c) | (d) | Type | mol% | mol% | mAh/g | mAh/g | % |
| Example 1 | 1.02 | 0.82 | 0.15 | 0.03 | Mn | 1.0 | 30 | 195 | 175 | 89.7 |
| Example 2 | 1.02 | 0.82 | 0.15 | 0.03 | Mn | 1.0 | 10 | 195 | 170 | 87.2 |
| Example 3 | 1.02 | 0.82 | 0.15 | 0.03 | Mn | 1.0 | 50 | 192 | 172 | 89.6 |
| Example 4 | 1.02 | 0.82 | 0.15 | 0.03 | Mn | 0.5 | 30 | 193 | 173 | 89.6 |
| Example 5 | 1.02 | 0.82 | 0.15 | 0.03 | Mn | 1.5 | 30 | 190 | 170 | 89.5 |
| Example 6 | 1.00 | 0.82 | 0.15 | 0.03 | Mn | 1.0 | 30 | 194 | 174 | 89.7 |
| Example 7 | 1.02 | 0.90 | 0.07 | 0.03 | Mn | 1.0 | 30 | 200 | 179 | 89.5 |
| Example 8 | 1.02 | 0.82 | 0.15 | 0.03 | V | 1.0 | 30 | 194 | 173 | 89.2 |
| Example 9 | 1.02 | 0.82 | 0.15 | 0.03 | Mg | 1.0 | 30 | 193 | 173 | 89.6 |
| Example 10 | 1.02 | 0.82 | 0.15 | 0.03 | Ti | 1.0 | 30 | 194 | 173 | 89.2 |
| Example 11 | 1.02 | 0.82 | 0.15 | 0.03 | Al | 1.0 | 30 | 194 | 175 | 90.2 |
| Comparative Example 1 | 1.02 | 0.82 | 0.15 | 0.03 | Mn | 1.0 | - | 180 | 160 | 88.9 |

## Claims

1. A positive electrode active material for all-solid lithium ion batteries, the positive electrode active material comprising:
a core positive electrode active material having a composition represented by the following formula:
LiₐNi_{b}Co_{c}M_{d}O₂
in which M is at least one element selected from Mn, V, Mg, Ti and Al, 1.00 ≤ a ≤ 1.02, 0.8 ≤ b ≤ 0.9, and b + c + d = 1; and
a coated portion formed on a surface of the core positive electrode active material,
wherein the coated portion comprises a layer of lithium niobate and a carbon layer in this order, from the surface of the core positive electrode active material,
wherein a ratio of a content of Nb in the coated portion is from 0.5 to 1.5 mol% relative to the total content of Ni, Co and M in the core positive electrode active material, and
wherein a ratio of a content of carbon in the coated portion is from 10 to 50 mol% relative to the content of Nb in the coated portion.

2. The positive electrode active material for all-solid lithium ion batteries according claim 1, wherein the carbon of the coated portion is elemental carbon.

3. A positive electrode for all-solid lithium ion batteries, comprising the positive-electrode active material for all-solid lithium ion batteries according to any one of claims 1 to 2.

4. An all-solid lithium ion battery, comprising: the positive electrode for all-solid lithium ion batteries according to claim 3; a negative electrode; and a solid electrolyte.

5. A method for producing the positive electrode active material for all-solid lithium ion batteries according to any one of claims 1 to 2, the method comprising:
coating the entire surface of the core positive electrode active material with lithium niobate; and
after coating the entire surface with the lithium niobate, further coating it with carbon using a carbon target material by means of barrel sputtering.

## Patentansprüche

1. Positivelektroden-Aktivmaterial für Festkörper-Lithium-Ionen-Batterien, wobei das Positivelektroden-Aktivmaterial umfasst:
ein Positivelektroden-Aktivmaterial des Kerns mit einer Zusammensetzung, die durch die folgende Formel wiedergegeben wird:
LiₐNi_{b}CO_{c}M_{d}O₂
wobei M mindestens ein Element ausgewählt aus Mn, V, Mg, Ti und Al ist, 1,00 ≤ a ≤ 1,02, 0,8 ≤ b ≤ 0,9, und b + c + d = 1; und
einen beschichteten Anteil, der auf einer Oberfläche des Positivelektroden-Aktivmaterials des Kerns gebildet ist,
wobei der beschichtete Anteil eine Schicht aus Lithiumniobat und eine Kohlenstoffschicht in dieser Reihenfolge von der Oberfläche des Positivelektroden-Aktivmaterials des Kerns aus umfasst,
wobei ein Verhältnis eines Gehalts an Nb in dem beschichteten Anteil 0,5 bis 1,5 Mol.% beträgt, bezogen auf den Gesamtgehalt an Ni, Co und M in dem Positivelektroden-Aktivmaterial des Kerns, und
wobei ein Verhältnis eines Gehalts an Kohlenstoff in dem beschichteten Anteil 10 bis 50 Mol.% beträgt, bezogen auf den Gehalt an Nb in dem beschichteten Anteil.

2. Positivelektroden-Aktivmaterial für Festkörper-Lithium-Ionen-Batterien nach Anspruch 1, wobei der Kohlenstoff des beschichteten Anteils elementarer Kohlenstoff ist.

3. Positive Elektrode für Festkörper-Lithium-Ionen-Batterien, umfassend das Positivelektroden-Aktivmaterial für Festkörper-Lithium-Ionen-Batterien gemäß einem der Ansprüche 1 bis 2.

4. Festkörper-Lithium-Ionen-Batterie, umfassend: die positive Elektrode für Festkörper-Lithium-Ionen-Batterien gemäß Anspruch 3; eine negative Elektrode; und einen festen Elektrolyten.

5. Verfahren zur Herstellung des Positivelektroden-Aktivmaterials für Festkörper-Lithium-Ionen-Batterien gemäß einem der Ansprüche 1 bis 2, wobei das Verfahren umfasst:
Beschichten der gesamten Oberfläche des Positivelektroden-Aktivmaterial des Kerns mit Lithiumniobat; und
nach Beschichten der gesamten Oberfläche mit dem Lithiumniobat weiteres Beschichten derselben mit Kohlenstoff unter Verwendung eines Kohlenstoff-Targetmaterials mittels Trommelsputtern.

## Revendications

1. Matériau actif d'électrode positive pour batteries au lithium-ion tout solide, le matériau actif d'électrode positive comprenant :
un matériau actif d'électrode positive de noyau, ayant une composition représentée par la formule suivante :
LiₐNi_{b}Co_{c}MaO₂
dans lequel M est au moins un élément sélectionné parmi Mn, V, Mg, Ti et Al, 1,00 ≤ a ≤ 1,02, 0,8 ≤ b ≤ 0,9 et b + c + d = 1 ; et
une partie revêtue formée sur une surface du matériau actif d'électrode positive de noyau,
dans lequel la partie revêtue comprend une couche de niobate de lithium et une couche de carbone dans cet ordre, à partir de la surface du matériau actif d'électrode positive de noyau,
dans lequel un rapport d'une teneur en Nb dans la partie revêtue est de 0,5 à 1,5 % en moles par rapport à la teneur totale en Ni, en Co et en M dans le matériau actif d'électrode positive de noyau, et
dans lequel un rapport d'une teneur en carbone dans la partie revêtue est de 10 à 50 % en moles par rapport à la teneur en Nb dans la partie revêtue.

2. Matériau actif d'électrode positive pour batteries au lithium-ion tout solide selon la revendication 1, dans lequel le carbone de la partie revêtue est du carbone élémentaire.

3. Électrode positive pour batteries au lithium-ion tout solide, comprenant le matériau actif d'électrode positive pour batteries au lithium-ion tout solide selon l'une quelconque des revendications 1 à 2.

4. Batterie au lithium-ion tout solide, comprenant : l'électrode positive pour les batteries au lithium-ion tout solide selon la revendication 3 ; une électrode négative ; et un électrolyte solide.

5. Procédé de fabrication du matériau actif d'électrode positive pour les batteries au lithium-ion tout solide selon l'une quelconque des revendications 1 à 2, le procédé comprenant :
le recouvrement de toute la surface du matériau actif d'électrode positive de noyau avec du niobate de lithium : et
après le recouvrement de toute la surface avec le niobate de lithium, un recouvrement supplémentaire avec du carbone à l'aide d'un matériau cible de carbone par pulvérisation cathodique.
